# EUROPEAN PATENT APPLICATION

(11) **EP 0 533 087 A1**
(43) Date of publication of application: **24.03.1993**
(21) Application number: 92115684.0
(22) Date of filing: 14.09.1992
(51) Int. Cl.: H01L 33/00, H01L 31/0203

(54) **Container for optical pulse-emitting/receiving devices**

(30) Priority: 19.09.1991 IT MO910058 U
(71) Applicant: M.D. MICRO DETECTORS S.p.A., I-41100 Modena (IT)
(72) Inventor: Iori, Paolo, I-41100 Modena (IT)
(74) Representative: Modiano, Guido, Dr.-Ing.

(57) **Abstract**

A container for optical pulse-emitting/receiving devices comprising a case (1) made of transparent material which is suitable to contain a circuit (2) for emitting/receiving the optical pulses and is sealed tight. The case has a sheet (5) of opaque material which is applied on its surface and is suitable to form a shielding barrier which extends over the surface so as to leave free a longitudinal slit (6) for the emission and reception of the optical pulses.

## Description

The present invention relates to a container for optical pulse-emitting/receiving devices.

As is known, optical pulse-emitting/receiving devices are provided with a preferably sealed container which encloses the circuit for sending and receiving the signal. Said container is currently manufactured exclusively with a parallelepipedal shape by molding or drawing a material suitable to act as an optical shield. One or more small openings are defined in the body thus obtained and are intended to allow signal sending and reception; a transparent element suitable to allow the passage of the optical signals is applied to said opening.

Manufacture of the container is thus rather complicated and relatively expensive. The cost of the mold and of the transparent element is in fact increased by the cost of the labor required to perform assembly, which if tightness is required entails operations for glueing, inserting gaskets and more.

The aim of the present invention is to solve the above problem, providing a container for optical pulse-emitting/receiving devices which is simple to manufacture and relatively economical in cost.

Within the scope of this aim, an object of the present invention is to provide a container for emitting/receiving devices which is safely reliable in operation and versatile in use.

This aim and this object and others which will become apparent are achieved, according to the invention, by the present container for optical pulse-emitting/receiving devices, which is characterized in that it comprises a case made of transparent material which is suitable to contain a circuit for emitting/receiving the optical pulses and is sealed tight, said case having a sheet of opaque material which is applied on its surface and is suitable to form a shielding barrier which extends over said surface so as to leave free a longitudinal slit for the emission and reception of said optical pulses.

Further characteristics and advantages of the present invention will become apparent from the following detailed description of a preferred embodiment thereof illustrated only by way of non-limitative example in the accompanying drawings, wherein:
figure 1 is an exploded perspective view of the container for optical pulse-emitting/receiving devices according to the present invention;
figure 2 is a longitudinal sectional view of said container.

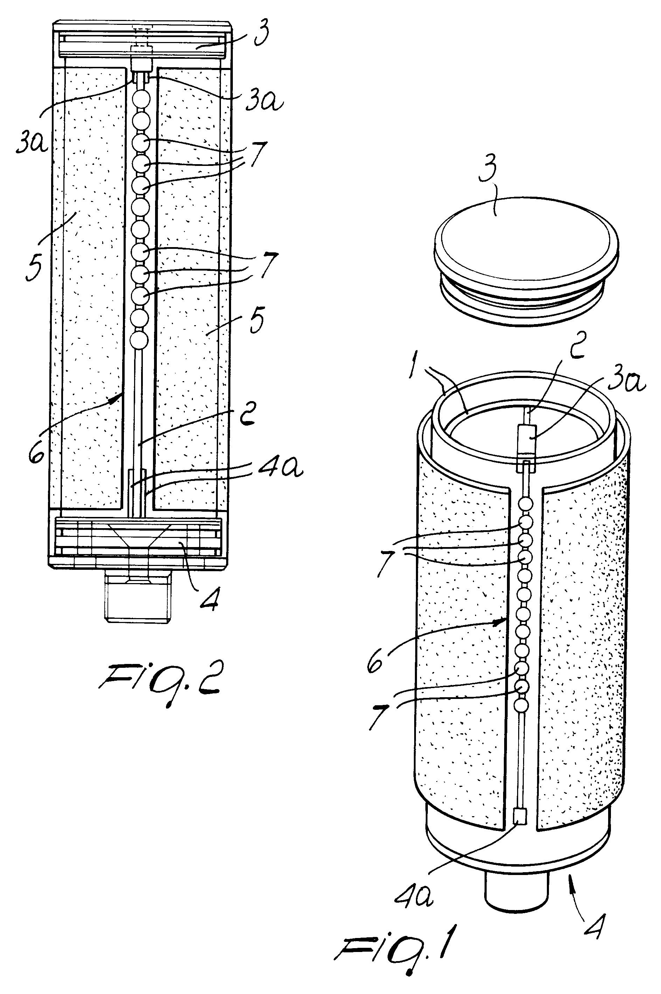

With particular reference to the above figures, the container for optical pulse-emitting/receiving devices has a cylindrical case 1 made of transparent material. The case 1 is suitable to internally contain a known circuit 2 which is intended to emit and receive the optical pulses by means of a series of optical elements 7.

The case 1 is closed tight, at its opposite ends, by means of respective plugs 3 and 4, so as to seal the seat of the circuit 2. The plugs 3 and 4 are provided with adapted elements 3a, 4a for the coupling of the circuit 2 which protrude inwardly into the cylindrical case 1.

The case 1 has a sheet 5 of opaque material applied on its cylindrical surface; preferably, the opaque sheet 5 has an adhesive face for application on the case 1.

The opaque sheet 5 forms a shielding barrier which extends over the surface of the case 1 so as to leave free a longitudinal slot 6 for the emission and reception of the optical pulses on the part of the circuit 2.

The described container is very simple and economical to manufacture. In particular, the saving in the costs for the manufacture of the molds or of the dies with respect to conventional containers is evident, in addition to avoiding the additional cost of the transparent element; the labor required for assembly is furthermore correspondingly reduced.

In the illustrated case, the opaque sheet 5 is applied on the outer surface of the case 1. Naturally, it is possible to provide for the application of said opaque sheet 5 on the internal surface of the case 1 in a similar manner.

In the practical manufacture of the device according to the invention, the materials employed, as well as the shape and dimensions, may be any according to the requirements.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. Container for optical pulse-emitting/receiving devices, characterized in that it comprises a case (1) made of transparent material which is suitable to contain a circuit (2) for emitting/receiving the optical pulses and is sealed tight, said case having a sheet (5) of opaque material which is applied on its surface and is suitable to form a shielding barrier which extends over said surface so as to leave free a longitudinal slit (6) for the emission and reception of said optical pulses, indications and/or markings related to the emitters/receivers being furthermore printable on the side of said sheet which faces outwardly.

2. Container according to claim 1, characterized in that said opaque sheet (5) has an adhesive face for application on the surface of said transparent case.

3. Container according to claim 1, characterized in that said case (1) has a cylindrical shape and is closed tight, at its opposite ends, by means of respective plugs (3,4) provided with means (3a,4a) for the coupling of said emission/reception circuit.
